(19) Europäisches Patentamt
European Patent Office
Office européen des brevets

(11) **EP 2 104 401 B1**

(12) **EUROPEAN PATENT SPECIFICATION**

(45) Date of publication and mention
of the grant of the patent:
**14.08.2013 Bulletin 2013/33**

(51) Int Cl.:
*H05B 37/02* (2006.01)  *H05B 39/04* (2006.01)
*H02M 1/08* (2006.01)  *H03K 5/1536* (2006.01)
*G01R 25/00* (2006.01)

(21) Application number: **08250907.6**

(22) Date of filing: **17.03.2008**

(54) **Zero crossing detection of line voltage/current of variable amplitude**

Nulldurchgangserkennung von Leitungsspannung/-strom unterschiedlicher Amplitude

Détection de passage à zéro de courant/tension de ligne d'amplitude variable

(84) Designated Contracting States:
**AT BE BG CH CY CZ DE DK EE ES FI FR GB GR
HR HU IE IS IT LI LT LU LV MC MT NL NO PL PT
RO SE SI SK TR**

(43) Date of publication of application:
**23.09.2009 Bulletin 2009/39**

(73) Proprietor: **Universal Lighting Technologies, Inc.
Nashville, Tennessee 37214 (US)**

(72) Inventors:
• **Shet, Deepak
Schaumberg, Illinois (US)**

• **Li, Changsheng
Madison, Alabama 35758 (US)**
• **Dernovsek, John Jay
Madison, Alabama 35758 (US)**

(74) Representative: **Davies, Gregory Mark et al
Urquhart-Dykes & Lord LLP
Churchill House
Churchill Way
Cardiff CF10 2HH (GB)**

(56) References cited:
**EP-A- 0 408 534    JP-A- 60 128 516
US-B2- 6 580 230**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**FIELD OF THE INVENTION**

The present invention relates generally to a circuit for producing substantially constant width pulses based upon notches detected in an input AC power line signal having a variable amplitude. More particularly, the invention may be used to detect notches and produce constant width pulses in a ballast communication system that uses notches in a power line signal to communicate dimming information to a series of ballasts.

**BACKGROUND OF THE INVENTION**

Considering the prior art, EP 0408534 provides a dependable low cost AC power controller for phase delayed switching of AC power. This is achieved by a phase switched power controller which connects a load to an alternating current source for a controllable portion of each half cycle, as selected by the user. It comprises a first full wave rectifier connected to a voltage source and produces an output signal varying between zero and a predetermined peak. A low pass filtered full wave rectified signal is preferably obtained from a second full wave rectifier and a controllable DC reference voltage is obtained therefrom. The output of the first rectifier and the reference voltage are input into a voltage comparator. The output triggers a triac which corrects the load to the power source during a predetermined portion of the cycle beginning or ending at a time defined by the output of the comparator. In one embodiment, to set the reference voltage, the load must reach a stable power consumption level.

JP60128516 addresses the problem of power supply stabilisation by using a reference voltage generating circuit comprising a constant voltage power supply and a voltage division circuit and a switch element forming the voltage division control means.

AC power is subjected to phase control by a triac and applied to an exposure lamp. A lamp voltage is converted into an effective voltage via a transformer, a full wave rectifier and an effective value detecting circuit. The voltage is compared with a reference voltage from a reference voltage generating circuit at a differential amplifier circuit and its output in a sawtooth wave voltage.

The reference voltage generating circuit consists of a constant voltage power supply circuit, a voltage division circuit, and a switch element forming the voltage division control means. A voltage dividing ratio is changed by means of the on/off state of the switch element.

Neither EP0408534 nor JP60128516 address the problem of detecting or producing bits represented by notches in an input power voltage.

Circuits that produce a pulse based upon a notch detected in an AC power signal have been described in the prior art. For example, US Patent No. 6,580,230 teaches a dimmer circuit with a phase detector which monitors the phase angle difference between voltage and current applied to a gaseous discharge device. Changes in the phase angle between the power voltage and current are used to produce a pulse that is in turn used to transfer information to a plurality of ballasts that use the received voltages as a power supply. The circuit of the '230 patent uses a fixed reference point, such as a zero crossing, to determine a phase angle difference between the voltage and current. Using this method of data transmission, the width of a pulse created based upon the zero crossings varies dramatically with changes in the input voltage. Thus, when a pulse is created based upon the detected phase difference between the line voltage and current, the width of the pulse will vary for a low input line voltage, such as 108 V, and a high input line voltage, such as 305 V. This is important due to the fact that many modem electronic devices are designed to be used with either a 120 V or a 277 V input line voltage that has a tolerance of plus or minus 10%. The primary disadvantage of using the prior art zero crossing detection circuit is that when the generated pulse width changes due to changes in the input voltage, detection of the pulses produced becomes more difficult and the output of the detection circuit is difficult to interpret. This makes the transmission and reception of data complicated and unreliable.

Therefore, what is needed is a receiver circuit for detecting data bits represented by notches in an input power voltage that generates a constant output pulse width irrespective of the input line voltage.

**SUMMARY OF THE INVENTION**

An embodiment of the present invention is directed towards a method for communicating information over a power line by detecting when the variable amplitude of a periodic line voltage or current having a known waveform is less than a reference amplitude, the method comprising from detecting a recent peak value of the periodic line voltage (26, 28, 32) or current;

dividing the recent peak value of the periodic line voltage or current by a ratio of a peak amplitude of a known amplitude version of the periodic line voltage or current to an amplitude of the known amplitude version that corresponds to a predetermined phase angle of the periodic line voltage or current to produce a reference amplitude, wherein the reference amplitude varies depending upon the recent peak value of the periodic line voltage or current, and
detecting when the variable amplitude of the periodic line voltage or current is less than said reference amplitude (24,30). If the voltage or current is sinusoidal, the ratio is the sine of the predetermined phase angle. A capacitor is used to detect and store the peak value of the voltage or current. The peak value of the line voltage or current is divided by the ratio to produce a reference amplitude, wherein the reference amplitude corresponds to the predetermined phase angle. A resistive divider is used to divide the peak value by the ratio and produce the reference amplitude. The reference amplitude is then detected to determine when the line voltage or current is at the predetermined phase angle. This is achieved by detecting when the variable amplitude of the periodic line voltage or current is less than the reference amplitude. A pulse is produced when the variable amplitude of the periodic line voltage falls below the reference amplitude wherein the ratio gives the phase angles at which the pulse starts and ends. The pulse is preferably used to communicate information from a power line communication controller to electronic ballasts in a lighting system. This information is used to dim lights in the lighting system.

Yet another embodiment of the present invention is directed toward an apparatus for communicating information over a power line using a periodic line voltage or current having a known waveform and a variable amplitude, the apparatus comprising: means, such as a capacitor, for detecting a recent peak value of the periodic line voltage or current; means, such as a resistive divider, for dividing the recent peak amplitude of the value of the periodic line voltage or current by a ratio of a peak amplitude of a known amplitude version of the periodic line voltage or current to an amplitude of the known amplitude version that corresponds to a predetermined phase angle of the periodic line voltage or current to produce a reference amplitude, wherein the reference amplitude varies depending upon the recent peak value. The apparatus then has means for detecting when the variable amplitude of the periodic line voltage or current is less than the reference amplitude. A substantially constant width pulse is produced when the variable amplitude of the periodic line voltage or current is less than the reference amplitude wherein the ratio gives the phase angles at which the pulse starts and ends. The pulse is used to communicate information from a power line communication controller to an electronic ballast in a lighting system. This information is used to dim lights in the lighting system

## BRIEF DESCRIPTION OF THE DRAWINGS

Fig. 1 is a graph of zero crossing pulse widths generated with a prior art detection circuit for zero crossings without a notch present in the power signal;

Fig. 2 is a graph of zero crossing pulse widths generated with a prior art detection circuit for zero crossings with a notch present in the power signal;

Fig 3. is a graph of zero crossing pulse widths generated with a circuit constructed in accordance with an embodiment of the present invention without a notch present in the power signal.

Fig. 4 is a graph of zero crossing pulse widths generated with a circuit constructed in accordance with an embodiment of the present invention with a notch present in the power signal;

Fig. 5 is a schematic drawing of a circuit for implementing an embodiment of the present invention;

Fig. 6 is a schematic drawing of a circuit for implementing another embodiment of the present invention; and

Fig. 7 is a graph of pulse widths detected by a circuit constructed in accordance with an embodiment of the present invention with an induced hysteresis in the power voltage such that an input voltage can be determined based upon the pulse width.

## DESCRIPTION OF THE PREFERRED EMBODIMENTS

The idea behind the present invention is to detect predefined phase angles on a sine wave power supply signal independent of the line voltage for use as starting and ending points in generating or detecting a pulse. The peak of the sine wave shaped power signal is referred to as the peak voltage, Vp. Vx is defined as a fraction of the peak voltage of the sine wave that corresponds to a desired phase angle of the sine wave. Thus, the inverse sine of the fraction Vx/Vp gives the angles at which the start and end of the pulse is generated or detected.

$$\theta_{start} = 180 - \sin^{-1}(Vx/Vp)$$

$$\theta_{end} = sin^{-1}(Vx/Vp)$$

Theoretically, $\theta_{start}$ will be between 90 and 180 degrees for the start of the pulse while $\theta_{end}$ will be between 0 and 90 degrees. The circuit can be further adapted to receive the input from a current transformer instead of a voltage. This will help to detect the zero crossing of the current and will generate a zero cross pulse that is of substantially constant width at different current levels.

An embodiment of the present invention is particularly useful in a power line communication (PLC) system for energy management of electronic ballasts, control of dimming ballasts or setting light levels for user defined light level ballasts. However, embodiments of the present invention can be utilized in any circuit where it is desirable to detect a consistent reference point on a given periodic signal. In addition, the present invention simplifies the required circuitry and, thus, allows for easy retrofit of the invention into existing installations with minimal effort. More particularly, embodiments of the present invention simplify the receiver circuits required in the dimming or controllable ballasts of a lighting system. Simplification of the receiving circuitry dramatically reduces the overall cost and complexity of such a system since most of the cost of a PLC controlled lighting system is in the ballast. This is due to the fact that multiple ballasts are controlled by a single PLC controller. The same circuit design used in the receivers may be used in the transmitter to generate the notch. The start of the pulse produced by a circuit constructed in accordance with an embodiment of the present invention can also be used to start notch generation. This is advantageous in that implementing the notch generation functionality in hardware and frees up processing power for use in other tasks.

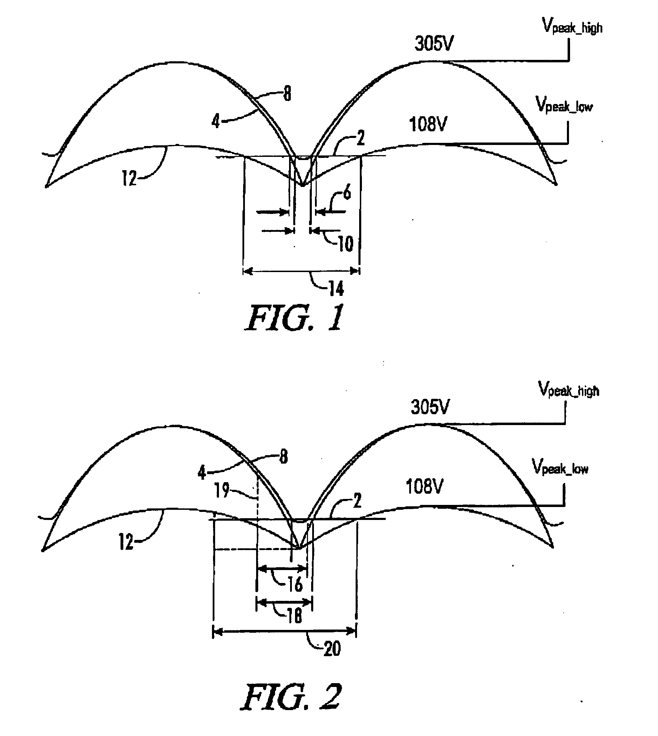

Referring now to FIG.1, a prior art scheme for detecting notches induced in an input power voltage signal is shown. A reference voltage level 2 is selected that represents a predetermined voltage level. Whenever the rectified high line power voltage 4 passes below the reference voltage level 2, a pulse 6 is generated that continues until the rectified high line voltage 4 rises above the reference voltage level 2. When the high line voltage 4 is delivering full power, a pulse 6 is created having a width represented by lines 6. However, if the high line voltage 8 is delivering minimum power, a slightly smaller width pulse 10 is created using the same reference voltage level 2. More importantly, if the ballast is designed to operate using different input power voltages, a low line power voltage 12 at full power produces a pulse width 14 that is substantially wider than the pulse widths 6 and 10 created when the ballast is powered by the high line power supply voltages 4 and 8. As discussed in more detail herein, the variation in the width of the zero crossing pulses 6, 10 and 14 makes the presence of a notch induced in the power line signal near the zero crossing difficult to detect.

The difficulty that results from the variation in the detected pulse width can better be understood by reference to FIG. 2. FIG. 2 is graph of the pulse widths 16, 18 and 20 produced with the high line power voltages 4 and 8 and low line power voltage 12 when a notch 19 has been induced at the zero crossing of the rectified power signal. As shown in FIG. 2, the pulse widths 16 and 18 produced with a high line power input signal 4 or 8 having a notch 19 is relatively small when compared to the low line maximum power pulse width 20. More importantly, the pulse width 14 for a low line power signal 12 without a notch, as shown in FIG. 1, is greater than the pulse width 18 for a highline power signal 4 with a notch 19, as shown in FIG. 2. Thus, the width of the zero crossing pulse can not be accurately used to determine the presence of a notch if the power line voltage varies significantly.

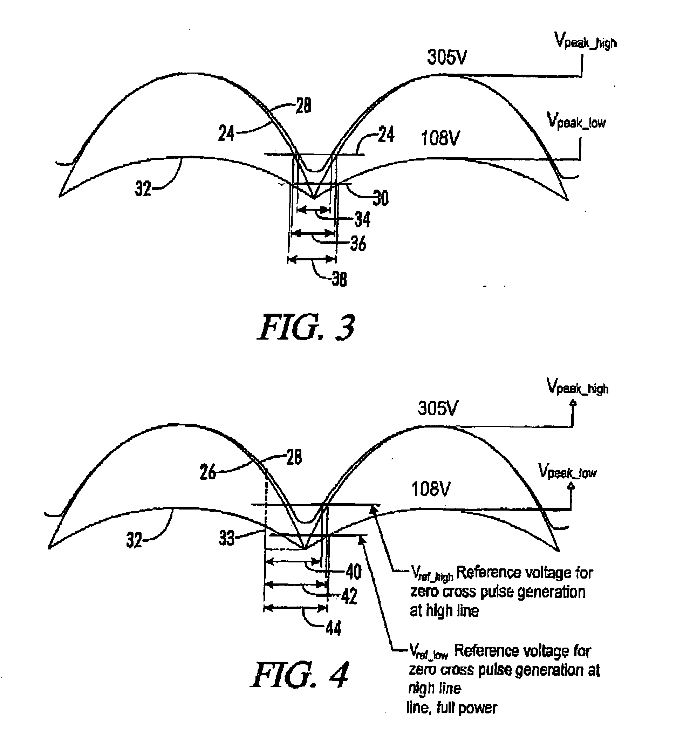

Referring now to FIG.3, a scheme for detecting notches induced in a power line signal in accordance with the present invention is shown. The present invention utilizes a first reference voltage 24 for a high line power signal 26 or 28 and a second reference voltage 30 for a low line power signal 32. As shown in FIG 3, the pulse widths 34, 36 and 38 created using this scheme for a high line power signal 26 or 28 and a low line power signal 32 that do not have an induced notch are approximately the same width. More importantly, as shown in FIG. 4, the pulse widths 40, 42 and 44 created for the low and high line power voltages having an induced notch 33 are all approximately equal and are all greater than the pulse widths produced when a notch 33 is not present- Thus, the pulse widths created in accordance with an embodiment of the present invention can be used to accurately detect the presence of a notch without regard to whether a high line power voltage or a low line power voltage is used to power the ballast. While the graphs of FIGS. 3 and 4 use two reference voltages, embodiments of the present invention actually create a reference voltage that varies depending upon the input voltage as discussed in more detail below.

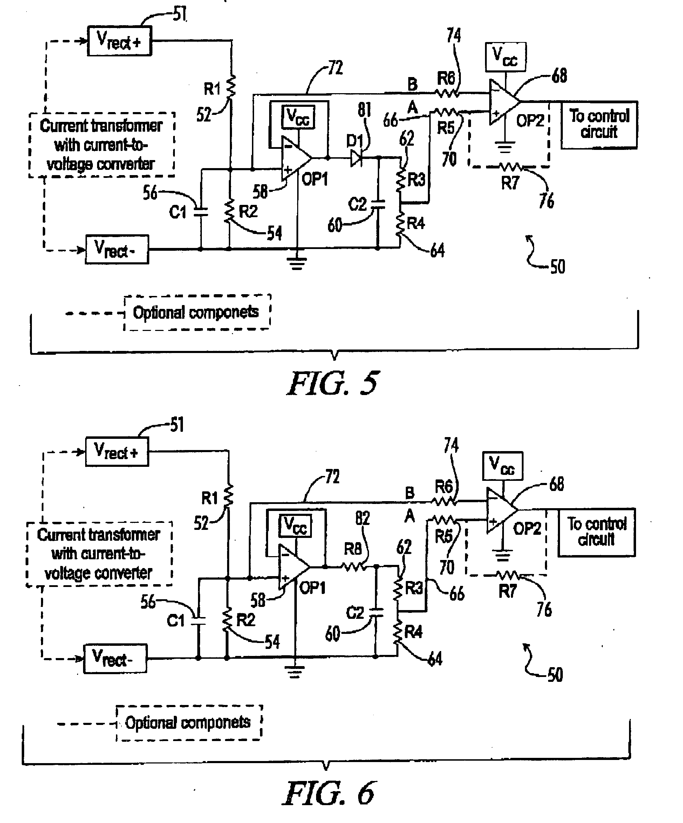

Referring now to FIG. 5, a circuit 50 for implementing a zero crossing detection scheme in accordance with an embodiment of the present invention is shown. The circuit 50 includes a resistive voltage divider that uses a first 52 and second 54 resistor to divide a rectified line voltage 51 down to a suitable level. A capacitor 56 is used to filter to the voltage signal between resistors 52 and 54. The voltage on the second resistor 54 is input into an operational amplifier 58 that is configured as a simple peak detector. The capacitor 60 has a capacitance that is selected such that the capacitor 60 charges up to the peak input signal on the operational amplifier's 58 non-inverting input. The resistors 62 and 64 are then used to divide the peak voltage down to a desired reference level. A voltage proportional to the peak voltage is obtained across capacitor 60 and the series combination of resistors 62 and 64. The voltage 66 between resistors 62 and 64 is fed to the non-inverting input of a second operational amplifier 68 through resistor 70. The divided down current rectified voltage 72 is fed to the inverting input of operational amplifier 68 through resistor 74. The output of the operational amplifier 68 is a pulse that is formed whenever the current voltage applied to the non-inverting input is less than the reference voltage provided to the inverting input. Since the reference voltage is proportional to the peak voltage, which is dynamically determined, any change in the peak input voltage will result in a corresponding change in the reference voltage. Thus, the circuit 50 adjusts for changes in the input power voltage. The waveforms obtained by the circuit 50 of FIG. 5 are shown in FIG .3 and FIG. 4. As can be seen in the figures, the pulse widths obtained are substantially constant for varying input voltages. The reference voltage level automatically changes from a low reference voltage at low line power to a high reference voltage at high line power. This keeps the pulse widths of the zero crossings substantially constant.

Referring now to FIG. 6 another embodiment of the present invention is shown. The circuit 80 of FIG. 6 uses an average detector to generate a first reference signal. The average value circuit is obtained by replacing the diode 81 in FIG. 5 with a resistor 82. The voltage generated on capacitor 60 is then the average value of the signal 72. Since the average value is $(2/\pi)Vp$ which is 0.636Vp. The inverse sine of 0.636 is approximately 40 degrees which is the maximum angle at which the circuit can generate a pulse.

Both the circuits of FIGS. 5 and 6 can be used to generate a pulse which is not symmetric around the zero crossing of the voltage but, rather has a phase lag. By increasing the value of capacitor 56, the generation of the start of the pulse can be delayed. Thus, it is possible to start the pulse very close to the actual zero crossing.

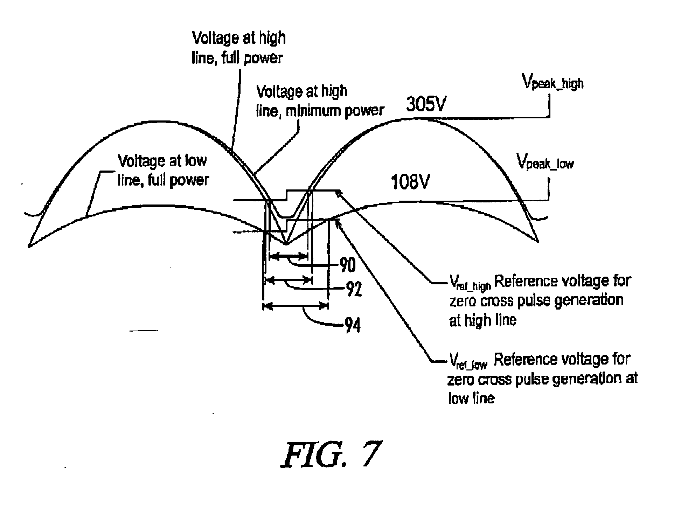

Resistor 76 may be used to add a little hysteresis to the signal if desired. Adding a little hysteresis with resistor 76 helps with regard to the noise immunity of the circuit. However, increasing the amount of hysteresis by decreasing the value of resistor 76 has the effect of making the pulse width vary with the line voltage. This effect can be used to sense line voltage in the transmitter or receiver as shown in FIG. 7. The trailing edge of the pulses 90, 92 and 94 depends on the line voltage. Thus, the width of the pulses can be used to determine the line voltage or current.

Thus, although there have been described particular embodiments of the present invention of a new and useful method and apparatus for Zero Crossing Detection of Line Voltage/Current of Variable Amplitude, modifications and variations may be made to the invention without departure from the scope of the invention as set forth in the appended claims.

**Claims**

1.  A method of dimming at least one light in a lighting system by using a substantially constant pulse width based upon a notch, said notch corresponding to a pre-determined phase angle detected in a periodic line voltage or current having a known waveform and variable amplitude, the method comprising the steps of:

    detecting a peak value of the periodic line voltage (26, 28, 32) or current;
    determining a ratio of a peak amplitude of a known amplitude version of the periodic line voltage or current to an amplitude of the known amplitude version that corresponds to the predetermined phase angle of the periodic line voltage or current;
    dividing the peak value of the periodic line voltage or current by said ratio to produce a reference amplitude (24, 30) which varies depending upon the peak value of the periodic line voltage or current;
    producing a pulse when the variable amplitude of the periodic line voltage or current is detected to be less than said reference amplitude (24,30) ; and
    using the pulse to communicate dimming information from a power line communication controller to at least one electronic ballast in the lighting system;
    wherein the periodic line voltage or current is a sine wave; and the inverse sine of the fraction Vx/Vp gives the phase angles at which the pulse starts and ends, wherein:

        Vp is the peak of the sine wave;

        Vx is a fraction of the peak voltage of the sine wave that corresponds to the predetermined phase angle of the sine wave, such that:

$$\Theta_{start} = 180 - \sin^{-1}(Vx/Vp)$$

        and

$$\Theta_{end} = \sin^{-1}(Vx/Vp).$$

2. The method of claim 1 wherein detecting a peak value of the periodic line voltage or current further comprises using a capacitor (60) to store the peak value of said periodic line voltage or current.

3. The method of claim 1 further comprising using a resistive divider (62, 64) to divide the peak value by the ratio and produce the reference amplitude (24, 30).

4. An apparatus for dimming at least one light in a lighting system by using a substantially constant pulse width based upon a notch, said notch corresponding to a pre-determined phase angle detected in a periodic line voltage (26, 28, 32) or current having a known waveform and variable amplitude, the apparatus comprising:

means for detecting a peak value of the periodic line voltage or current (58);
means for determining a ratio of a peak amplitude of a known amplitude version of the periodic line voltage or current to an amplitude of the known amplitude version that corresponds to the predetermined phase angle of the periodic line voltage or current ;
means for dividing the peak value of the periodic line voltage or current by said ratio to produce a reference amplitude (62, 64) which varies depending upon the peak value;
means for producing a pulse when the variable amplitude of the periodic line voltage or current (26, 28, 32) is detected to be less than said reference amplitude (68);
and
means for using the pulse to communicate dimming information from a power line communication controller to at least one electronic ballast in the lighting system;
wherein the periodic line voltage or current is a sine wave; and the inverse sine of the fraction Vx/Vp gives the phase angles at which the pulse starts and ends, wherein:

Vp is the peak of the sine wave;
Vx is a fraction of the peak voltage of the sine wave that corresponds to the predetermined phase angle of the sine wave, such that:

$$\Theta_{start} = 180 - \sin^{-1}(Vx/Vp)$$

and

$$\Theta_{end} = \sin^{-1}(Vx/Vp).$$

5. The apparatus of claim 4 wherein a capacitor (60) is used to detect the recent peak amplitude of the periodic line voltage or current (26, 28, 32).

6. The apparatus of claim 4 wherein the means for dividing further comprise a resistive divider.

**Patentansprüche**

1. Ein Verfahren zum Dimmen von mindestens einer Leuchte in einem Beleuchtungssystem durch Verwendung einer im Wesentlichen konstanten Impulslänge auf der Grundlage einer Kerbe, wobei besagte Kerbe einem vorbestimmten Phasenwinkel entspricht, der in einer periodischen Leitungsspannung oder einem periodischen Leitungsstrom mit einer bekannten Wellenform und variabler Amplitude erkannt wird, wobei das Verfahren folgende Schritte umfasst:

Erkennen eines Spitzenwertes der periodischen Leitungsspannung (26, 28, 32) oder des periodischen Leitungsstroms;
Bestimmung des Verhältnisses einer Spitzenamplitude einer bekannten Amplitudenversion der periodischen Leitungsspannung oder des periodischen Leitungsstroms zu einer Amplitude der bekannten Amplitudenversion, welche dem vorbestimmten Phasenwinkel der periodischen Leitungsspannung oder des periodischen Leitungsstroms entspricht;

Teilung des Spitzenwertes der periodischen Leitungsspannung oder des periodischen Leitungsstroms durch besagte Verhältniszahl zur Erzeugung einer Referenzamplitude (24, 30), die in Abhängigkeit von dem Spitzenwert der periodischen Leitungsspannung oder des periodischen Leitungsstroms variiert;

Erzeugung eines Impulses, wenn erkannt wird, dass die variable Amplitude der periodischen Leitungsspannung oder des periodischen Leitungsstroms kleiner ist als besagte Referenzamplitude (24, 30); und

Verwendung des Impulses zur Übermittlung der Dimminformationen von der Übertragungssteuerung einer Stromleitung an mindestens ein elektronisches Vorschaltgerät im Beleuchtungssystem,

wobei die periodische Leitungsspannung oder der periodische Leitungsstrom eine Sinuskurve ist und der Arkussinus des Bruches Vx/Vp die Phasenwinkel ergibt, bei denen der Impuls startet und endet, wobei:

Vp die Spitze der Sinuskurve ist;

Vx ein Bruchteil der Spitzenspannung der Sinuskurve ist, der dem vorbestimmten Phasenwinkel der Sinuskurve entspricht, so dass:

$$\theta_{start} = 180 - \sin^{-1} (Vx/Vp)$$

und

$$\theta_{end} = \sin^{-1} (Vx/Vp)$$

ist.

2. Das Verfahren nach Anspruch 1, wobei die Erkennung eines Spitzenwertes der periodischen Leitungsspannung oder des periodischen Leitungsstroms ferner die Verwendung eines Kondensators (60) zur Speicherung des Spitzenwertes der besagten periodischen Leitungsspanunng oder des periodischen Leitungsstroms umfasst.

3. Das Verfahren nach Anspruch 1, das ferner die Verwendung eines Widerstandsteilers (62, 64) zur Teilung des Spitzenwertes durch die Verhältniszahl und zur Erzeugung der Referenzamplitude (24, 30) umfasst.

4. Ein Gerät zum Dimmen von mindestens einer Leuchte in einem Beleuchtungssystem durch Verwendung einer im Wesentlichen konstanten Impulslänge auf der Grundlage einer Kerbe, wobei besagte Kerbe einem vorbestimmten Phasenwinkel entspricht, der in einer periodischen Leitungsspannung (26, 28, 32) oder einem periodischen Leitungsstrom mit einer bekannten Wellenform und variabler Amplitude erkannt wird. Das Gerät umfasst Folgendes:

Vorrichtung zur Erkennung eines Spitzenwertes der periodischen Leitungsspannung oder des periodischen Leitungsstroms (58);

Vorrichtung zur Bestimmung des Verhältnisses einer Spitzenamplitude einer bekannten Amplitudenversion der periodischen Leitungsspannung oder des periodischen Leitungsstroms zu einer Amplitude der bekannten Amplitudenversion, welche dem vorbestimmten Phasenwinkel der periodischen Leitungsspannung oder des periodischen Leitungsstroms entspricht;

Vorrichtung zur Teilung des Spitzenwertes der periodischen Leitungsspannung oder des periodischen Leitungsstroms durch besagte Verhältniszahl zur Erzeugung einer Referenzamplitude (62, 64), die in Abhängigkeit von dem Spitzenwert variiert;

Vorrichtung zur Erzeugung eines Impulses, wenn erkannt wird, dass die variable Amplitude der periodischen Leitungsspannung oder des periodischen Leitungsstroms (26, 28, 32) kleiner ist als besagte Referenzamplitude (68);

und

Vorrichtung zur Verwendung des Impulses zur Übermittlung der Dimminformationen von der Übertragungssteuerung einer Stromleitung an mindestens ein elektronisches Vorschaltgerät im Beleuchtungssystem,

wobei die periodische Leitungsspannung oder der periodische Leitungsstrom eine Sinuskurve ist und der Arkussinus des Bruches Vx/Vp die Phasenwinkel ergibt, bei denen der Impuls startet und endet, wobei:

Vp die Spitze der Sinuskurve ist;

Vx ein Bruchteil der Spitzenspannung der Sinuskurve ist, der dem vorbestimmten Phasenwinkel der Sinuskurve entspricht, so dass:

$$\theta_{start} = 180 - \sin^{-1}(Vx/Vp)$$

und

$$\theta_{end} = \sin^{-1}(Vx/Vp)$$

ist.

**5.** Das Gerät nach Anspruch 4, bei dem ein Kondensator (60) zur Erkennung der letzten Spitzenamplitude der periodischen Leitungsspannung oder des periodischen Leitungsstroms (26, 28, 32) verwendet wird.

**6.** Das Gerät nach Anspruch 4, wobei die Vorrichtung zur Teilung ferner einen Widerstandsteiler umfasst.

**Revendications**

**1.** Procédé de gradation d'au moins une lumière dans un système d'éclairage en utilisant une largeur d'impulsion sensiblement constante basée sur une encoche, ladite encoche correspondant à un angle de phase prédéterminé détecté dans un courant ou une tension de ligne périodique ayant une forme d'onde connue et une amplitude variable, le procédé comprenant les étapes suivantes :

la détection d'une valeur de crête du courant ou de la tension de ligne périodique (26, 28, 32) ;
la détermination d'un rapport entre une amplitude de crête d'une version d'amplitude connue du courant ou de la tension de ligne périodique et une amplitude de la version d'amplitude connue qui correspond à l'angle de phase prédéterminé du courant ou de la tension de ligne périodique ;
la division de la valeur de crête du courant ou de la tension de ligne périodique par ledit rapport pour produire une amplitude de référence (24, 30) qui varie en fonction de la valeur de crête du courant ou de la tension de ligne périodique ;
la production d'une impulsion lorsque l'amplitude variable du courant ou de la tension de ligne périodique est détectée comme étant inférieure à ladite amplitude de référence (24, 30) ; et
l'utilisation de l'impulsion pour communiquer des informations de gradation d'un contrôleur de communication de ligne électrique à au moins un ballast électronique dans le système d'éclairage ;
dans lequel le courant ou la tension de ligne périodique est une onde sinusoïdale ; et l'arc sinus de la fraction Vx/Vp donne les angles de phase auxquels l'impulsion commence et finit, dans lequel :

Vp est la crête de l'onde sinusoïdale ;
Vx est une fraction de la tension de crête de l'onde sinusoïdale qui correspond à l'angle de phase prédéterminé de l'onde sinusoïdale, de sorte que :

$$\theta_{start} = 180 - \sin^{-1}(Vx/Vp)$$

et

$$\theta_{end} = \sin^{-1}(Vx/Vp).$$

**2.** Procédé selon la revendication 1, dans lequel la détection d'une valeur de crête du courant ou de la tension de ligne périodique comprend en outre l'utilisation d'un condensateur (60) pour stocker la valeur de crête dudit courant ou de ladite tension de ligne périodique.

**3.** Procédé selon la revendication 1, comprenant en outre l'utilisation d'un diviseur résistif (62, 64) pour diviser la valeur de crête par le rapport et produire l'amplitude de référence (24, 30).

**4.** Dispositif de gradation d'au moins une lumière dans un système d'éclairage en utilisant une largeur d'impulsion sensiblement constante basée sur une encoche, ladite encoche correspondant à un angle de phase prédéterminé détecté dans un courant ou une tension de ligne périodique (26, 28, 32) ayant une forme d'onde connue et une amplitude variable, le dispositif comprenant :

des moyens pour détecter une valeur de crête du courant ou de la tension de ligne périodique (58) ;
des moyens pour déterminer un rapport entre une amplitude de crête d'une version d'amplitude connue du courant ou de la tension de ligne périodique et une amplitude de la version d'amplitude connue qui correspond à l'angle de phase prédéterminé du courant ou de la tension de ligne périodique ;
des moyens pour diviser la valeur de crête du courant ou de la tension de ligne périodique par ledit rapport pour produire une amplitude de référence (62, 64) qui varie en fonction de la valeur de crête ;
des moyens pour produire une impulsion quand l'amplitude variable du courant ou de la tension de ligne périodique (26, 28, 32) est détectée comme étant inférieure à ladite amplitude de référence (68) ; et
des moyens pour utiliser l'impulsion pour communiquer des informations de gradation d'un contrôleur de communication de ligne électrique à au moins un ballast électronique dans le système d'éclairage ;
dans lequel le courant ou la tension de ligne périodique est une onde sinusoïdale ; et l'arc sinus de la fraction Vx/Vp donne les angles de phase auxquels l'impulsion commence et finit, dans lequel :

Vp est la crête de l'onde sinusoïdale ;
Vx est une fraction de la tension de crête de l'onde sinusoïdale qui correspond à l'angle de phase prédéterminé de l'onde sinusoïdale, de sorte que :

$$\theta_{start} = 180 - \sin^{-1}(Vx/Vp)$$

et

$$\theta_{end} = \sin^{-1}(Vx/Vp).$$

**5.** Dispositif selon la revendication 4, dans lequel un condensateur (60) est utilisé pour détecter l'amplitude de crête récente du courant ou de la tension de ligne périodique (26, 28, 32).

**6.** Dispositif selon la revendication 4, dans lequel les moyens de division comprennent en outre un diviseur résistif.

**FIG. 1**

**FIG. 2**

$V_{peak\_high}$

305V

28

24    24    108V    $V_{peak\_low}$

32

30

34

36

38

**FIG. 3**

$V_{peak\_high}$

305V

28

26    108V    $V_{peak\_low}$

32    33

40

42

44

$V_{ref\_high}$ Reference voltage for zero cross pulse generation at high line

**FIG. 4**

$V_{ref\_low}$ Reference voltage for zero cross pulse generation at high line line, full power

**FIG. 5**

**FIG. 6**

Voltage at high
line, full power

Voltage at high
line, minimum power   305V

$V_{peak\_high}$

Voltage at low
line, full power

$V_{peak\_low}$

108V

90

92

94

$V_{ref\_high}$ Reference voltage for
zero cross pulse generation
at high line

$V_{ref\_low}$ Reference voltage for
zero cross pulse generation at
low line

*FIG. 7*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0408534 A
- JP 60128516 B

- US 6580230 B